# EUROPÄISCHE PATENTSCHRIFT

(11) **EP 0 514 570 B1**
(45) Veröffentlichungstag und Bekanntmachung des Hinweises auf die Patenterteilung: **14.12.1994**
(21) Anmeldenummer: 91108295.6
(22) Anmeldetag: 23.05.1991
(51) Int. Cl.: G05F 3/00, H03K 17/95

(54) **Elektrische Schaltungsanordnung mit einem ein Einstellelement aufweisenden Bauteil**
Electrical circuit arrangement with a component including an adjusting element
Montage électrique avec un composant présentant un élément d'ajustage

(43) Veröffentlichungstag der Anmeldung: 25.11.1992
(73) Patentinhaber: i f m electronic gmbh, D-45127 Essen (DE)
(72) Erfinder: Lamarche, Jean-Luc, Dipl.-Ing., W-7993 Langenargen (DE)
(74) Vertreter: Gesthuysen, Hans Dieter, Dipl.-Ing.

(56) Entgegenhaltungen:
- EP-A- 0 153 719
- EP-A- 0 178 844
- EP-A- 0 268 255
- EP-A- 0 399 649
- DE-A- 3 608 639
- GB-A- 2 011 130
- DATA CONVERSION SEMINAR 1984, Analog Devices Inc., Boston, USA.

## Beschreibung

Die Erfindung betrifft einen induktiven Näherungsschalter, mit mindestens einem hinsichtlich seines die Schaltungsanordnung beeinflussenden Wertes einstellbarem Bauteil, z. B. einem Widerstand, wobei das einstellbare Bauteil mindestens ein Einstellelement aufweist, und wie in Anspruch 1 definiert wird.

Wesentlicher Bestandteil eines induktiven Näherungsschalters ist ein von außen beeinflußbarer Oszillator. Dabei gilt für den Oszillator, solange ein Metallteil einen vorgegebenen Abstand noch nicht erreicht hat, K x V = 1 mit K = Rückkopplungsfaktor und V = Verstärkungsfaktor des Oszillators; d. h. der Oszillator schwingt. Erreicht das entsprechende Metallteil den vorgegebenen Abstand, so führt die zunehmende Bedämpfung des Oszillators zu einer Verringerung des Verstärkungsfaktors V, so daß V x V < 1 wird; d. h. der Oszillator hört auf zu schwingen. Abhängig von den unterschiedlichen Zuständen des Oszillators wird ein zu dem induktiven Näherungsschalter gehörender elektronischer Schalter, z. B. ein Transistor, ein Thyristor oder ein Triac, gesteuert. Zum Stand der Technik in bezug auf induktive Näherungsschalter wird auf die DE-OS 37 22 334 und die DE-OS 37 22 335 und auf die in diesen vorveröffentlichten Druckschriften aufgeführten deutschen Offenlegungsschriften, Auslegeschriften und Patentschriften verwiesen.

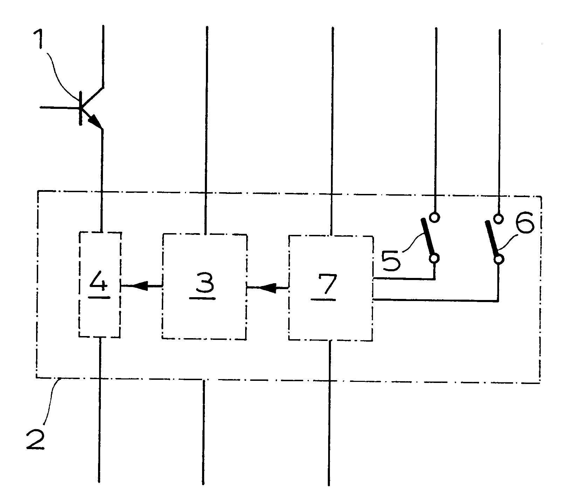

Einleitend ist bereits darauf hingewiesen, daß es sich bei dem Bauteil, dessen einstellbarer Wert die Schaltungsanordnung beeinflußt, um einen Widerstand handeln kann. Das kann z. B. der Emitterwiderstand des Oszillatortransistors des Oszillators eines induktiven Näherungsschalters sein (vgl. den Emitterwiderstand 14 in der Zeichnung der DE-PS 19 66 178). Da die Verstärkung des Oszillatortransistors annähernd gleich dem Verhältnis von Kollektorwiderstand zu Emitterwiderstand ist, beeinflußt also der Wert des Emitterwiderstandes die Verstärkung des Oszillatortransistors und damit den Schaltabstand des induktiven Näherungsschalters; durch Einstellung des Wertes des Emitterwiderstandes kann also der Schaltabstand des induktiven Näherungsschalters eingestellt werden.

Im Stand der Technik, von dem die Erfindung ausgeht, werden als einstellbare Widerstände Potentiometer verwendet. Diese Potentiometer sind zwar relativ billig und leicht bedienbar, jedoch auch mit einer Mehrzahl von Nachteilen behaftet. Zunächst sind Potentiometer als mechanische Bauteile störanfällig, insbesondere erschütterungsempfindlich, mit relativ großen Toleranzen versehen und in SMD-Ausführung nicht immer erhältlich. Darüber hinaus ist die Einstellung manchmal schwierig, treten Vergußprobleme auf und ist eine aufwendige Mechanik erforderlich, wenn eine bestimmte Schutzart zu gewährleisten ist. Schießlich müssen "empfindliche Signale", beispielsweise der Spannungsabfall am Emitterwiderstand, an "ungünstige Stellen" transportiert werden, d. h. an Stellen transportiert werden, die eine Beeinflussung der "empfindlichen Signale" nicht hinreichend sicher ausschließen.

Der Erfindung liegt nun die Aufgabe zugrunde, die eingangs in ihrem grundsätzlichen Aufbau beschriebene und danach in Verbindung mit einem induktiven Näherungsschalter weiter erläuterte Schaltungsanordnung hinsichtlich der Einstellbarkeit des einstellbaren Bauteils zu verbessern.

Die erfindungsgemäße elektrische Schaltungsanordnung, bei der die zuvor hergeleitete und dargelegte Aufgabe gelöst ist, ist nun zunächst und im wesentlichen dadurch gekennzeichnet, daß als Einstellelement ein nichtflüchtiger Speicher vorgesehen ist und in dem Speicher der die Schaltungsanordnung beeinflussende Wert des einstellbaren Bauteils als Digitalwort einstellbar ist. Erfindungsgemäß besteht also das einstellbare Bauteil, dessen einstellbarer Wert die Schaltungsanordnung beeinflußt, aus einem elektronischen Einstellelement, nämlich einem nichtflüchtigen Speicher, und, z. B. bei einer Ausführung als einstellbarer Widerstand, aus mehreren Widerstandselementen, aus denen mit Hilfe des Speichers - und ggf. eines elektronischen Netzwerks - der im Ergebnis wirksame Widerstand dargestellt wird.

Im einzelnen gibt es nun verschiedene Möglichkeiten, die Lehre der Erfindung auszugestalten und weiterzubilden. Das wird im folgenden anhand einer lediglich ein Ausführungsbeispiel schematisch darstellenden Zeichnung erläutert.

Die einzige Figur zeigt - stark schematisiert und nur ausschnittweise - eine elektrische Schaltungsanordnung, nämlich einen ganz geringfügigen Teil eines induktiven Näherungsschalters. Dieser Näherungsschalter weist einen im übrigen nicht dargestellten Oszillator auf, zu dem ein Oszillatortransistor 1 mit einem Emitterwiderstand gehört. Hinsichtlich des üblichen Aufbaus eines induktiven Näherungsschalters und des üblichen Aufbaus des Oszillators eines solchen induktiven Näherungsschalters wird auf die vorveröffentlichten Druckschriften verwiesen, die in der DE-OS 37 22 334 und in der DE-OS 37 22 335 angeführt sind, insbesondere auf die DE-PS 19 66 178. Der Emitterwiderstand ist das einstellbare Bauteil 2, dessen Wert die Schaltungsanordnung beeinflußt, mit dem hier also der Schaltabstand des induktiven Näherungsschalters eingestellt werden kann.

Das einstellbare Bauteil 2, im dargestellten Ausführungsbeispiel also der Emitterwiderstand des Oszillatortransistors 1, weist ein Einstellelement auf.

Erfindungsgemäß ist als Einstellelement ein nichtflüchtiger Speicher 3 vorgesehen und ist in dem Speicher 3 der die Schaltungsanordnung beeinflussende Wert des einstellbaren Bauteils 2, im Ausführungsbeispiel also der Wert des Emitterwiderstandes, als Digitalwort einstellbar. Der Emitterwiderstand als einstellbares Bauteil 2 besteht also aus dem Speicher 3 als elektronisches Einstellelement und aus mehreren Widerstandselementen 4, aus denen mit Hilfe des Speichers 3 - und eines hier nicht dargestellten elektronischen Netzwerks - der im Ergebnis wirksame Wert des Emitterwiderstandes dargestellt wird.

Im dargestellten Ausführungsbeispiel erfolgt die Einstellung des Digitalworts zur Einstellung des die Schaltungsanordnung beeinflussenden Wertes des einstellbaren Bauteils 2, also des Emitterwiderstands, durch Betätigung von zwei kontaktlosen Schaltern 5, 6, die nur schematisch dargestellt sind und z. B. induktiv, kapazitiv, optoelektronisch oder den Halleffekt ausnutzend arbeiten können.

Im einzelnen kann die erfindungsgemäße Schaltungsanordnung so realisiert sein, daß der Speicher 3 bei jeder Betätigung des Schalters 5 um einen Schritt "hochläuft" und bei jeder Betätigung des Schalters 6 um einen Schritt "runterläuft". Vorzugsweise ist die erfindungsgemäße Schaltungsanordnung jedoch so realisiert, daß der Speicher 3 bei einer Betätigung des Schalters 5 automatisch "hochläuft" und bei einer Betätigung des Schalters 6 automatisch "runterläuft". Dabei kann das "Hochlaufen" bzw. das "Runterlaufen" mit unterschiedlichen Laufgeschwindigkeiten erfolgen, also "Langsames Hochlaufen" und "Schnelles Hochlaufen" bzw. "Langsames Runterlaufen" und "Schnelles Runterlaufen" möglich sein. Das kann durch ein unterschiedlich langes Betätigen der Schalter 5, 6 realisiert sein; ein kurzes Betätigen der Schalter 5, 6 kann zu einer geringen Laufgeschwindigkeit, ein längeres Betätigen der Schalter 5, 6 zu einer höheren Laufgeschwindigkeit führen.

Statt zwei Schalter 5, 6 vorzusehen, kann man auch mit nur einem Schalter auskommen. Dann führt beispielsweise eine erste Betätigung des Schalters zu einem "Hochlaufen", eine kurz nach der ersten Betätigung erfolgende zweite Betätigung des Schalters zu einem "Runterlaufen".

Weiter oben ist bereits ausgesagt, daß bei der erfindungsgemäßen Schaltungsanordnung der Speicher 3 bei einer der Einstellung des die Schaltungsanordnung beeinflussenden Wertes des einstellbaren Bauteils 2 dienenden Betätigung automatisch "hochläuft" oder "runterläuft". In diesem Zusammenhang kann die erfindungsgemäße Schaltungsanordnung so realisiert sein, daß das "Hochlaufen" bzw. das "Runterlaufen" des Speichers 3 durch eine erste Betätigung des Schalters 5 bzw. des Schalters 6 beginnt und nach einer zweiten Betätigung des Schalters 5 bzw. des Schalters 6 endet. Nach einer weiteren Lehre der Erfindung, der besondere Bedeutung zukommt, endet jedoch das "Hochlaufen" bzw. das "Runterlaufen" des Speichers 3 automatisch, wenn der die Schaltungsanordnung beeinflussende Wert des einstellbaren Bauteils 2 den Sollwert erreicht hat. Dabei kann das Erreichen des Sollwertes des die Schaltungsanordnung beeinflussenden Wertes des einstellbaren Bauteils 2, hier also des Emitterwiderstandes, dadurch erkannt werden, daß die Schaltungsanordnung einen signifikanten Schaltungszustand eingenommen hat. Bei einem induktiven Näherungsschalter kann also ein den Näherungsschalter beeinflussendes Metallteil mit gewolltem Schaltabstand zum Näherungsschalter positioniert werden. Dann kann durch Betätigung des Schalters 5 der Speicher 3 so lange "hochlaufen" (bzw. durch Betätigung des Schalters 6 so lange "runterlaufen") bis der induktive Näherungsschalter "anspricht", also der Oszillator signifikant beeinflußt wird, nämlich dann, wenn er zuvor im schwingenden Zustand gewesen ist, in den nicht-schwingenden Zustand kommt, bzw. dann, wenn er zuvor im nicht-schwingenden Zustand gewesen ist, in den schwingenden Zustand kommt. Diese Lehre der Erfindung, der, wie bereits ausgeführt, besondere Bedeutung zukommt, führt also dazu, daß bei einem induktiven Näherungsschalter der Schaltabstand nicht mehr werkseitig eingestellt werden muß, vielmehr der Verwender eines solchen induktiven Näherungsschalters den jeweils gewünschten Schaltabstand selbst einstellen kann.

Schließlich geht eine weitere Lehre der Erfindung dahin, einen µController 7 vorzusehen. Dann kann mit Hilfe des µControllers 7 die Aktivierung der Schalter 5, 6 regelmäßig überprüft werden. Es kann aber auch die Aktivierung der Schalter 5, 6 durch einen "Interrupt" hervorgerufen werden und der "Interrupt" den µController 7 in den "Parameterprogrammiermodus" aktivieren. Ist dann noch ein nicht dargestelltes Display, z. B. ein LCD, vorgesehen, dann kann die Programmierung im "Konversationsmodus" erfolgen.

Dadurch, daß bei der erfindungsgemäßen Schaltungsanordnung die gesamte Programmierung kontaktlos erfolgt, kann die Schaltungsanordnung insgesamt in einem hermetisch abgeschlossenen Gehäuse untergebracht werden, so daß die geforderte Schutzart problemlos realisiert werden kann.

Ein wesentlicher Vorteil der erfindungsgemäßen Schaltungsanordnung besteht auch darin, daß dort, wo die Betätigung des Speichers 3 erfolgt, also dort, wo die Schalter 5, 6 realisiert sind, kein "empfindliches Signal" vorhanden sein muß. Im dargestellten Ausführungsbeispiel werden zwischen den Schaltern 5, 6 und den Widerstandselementen 4, an denen "empfindliche Signale" anstehen, "nur" logische Informationen transportiert.

## Patentansprüche

1. Induktiver Näherungsschalter mit mindestens einem hinsichtlich seines den Schaltabstand beeinflussenden Wertes einstellbarem Bauteil (4), z. B. einem Widerstand, wobei das einstellbare Bauteil (4) mindestens ein Einstellelement aufweist, **dadurch gekennzeichnet,** daß als Einstellelement ein nichtflüchtiger Speicher (3) vorgesehen ist, in dem Speicher (3) der den Schaltabstand beeinflussende Wert des einstellbaren Bauteils (4) als Digitalwort einstellbar ist, der Speicher (3) bei einer der Einstellung des den Schaltabstand beeinflussenden Wertes des einstellbaren Bauteils (4) dienenden Betätigung automatisch "hochläuft" oder "runterläuft" und das "Hochlaufen" bzw. das "Runterlaufen" des Speichers (3) automatisch endet, wenn der den Schaltabstand beeinflussende Wert des einstellbaren Bauteils (4) einen Sollwert erreicht hat.

2. Induktiver Näherungsschalter nach Anspruch 1, dadurch gekennzeichnet, daß die Einstellung des den Schaltabstand beeinflussenden Wertes des einstellbaren Bauteils (4), also des Digitalworts, durch Betätigung mindestens eines - vorzugsweise kontaktlosen - Schalters (5, 6) erfolgt.

3. Induktiver Näherungsschalter nach Anspruch 2, dadurch gekennzeichnet, daß der Schalter (5, 6) induktiv, kapazitiv, optoelektronisch oder den Halleffekt ausnutzend arbeitet.

4. Induktiver Näherungsschalter nach einem der Ansprüche 1 bis 3, dadurch gekennzeichnet, daß das "Hochlaufen" bzw. das "Runterlaufen" des Speichers (3) mit unterschiedlichen Laufgeschwindigkeiten erfolgt, also "Langsames Hochlaufen" und "Schnelles Hochlaufen" bzw. "Langsames Runterlaufen" und "Schnelles Runterlaufen" des Speichers (3) möglich ist.

5. Induktiver Näherungsschalter nach Anspruch 4, dadurch gekennzeichnet, daß durch ein unterschiedlich langes Betätigen unterschiedliche Laufgeschwindigkeiten des Speichers (3) realisierbar sind.

6. Induktiver Näherungsschalter nach einem der Ansprüche 3 bis 5, dadurch gekennzeichnet, daß das "Hochlaufen" bzw. das "Runterlaufen" des Speichers (3) durch eine erste Betätigung beginnt und nach einer zweiten Betätigung endet.

7. Induktiver Näherungsschalter nach einem der Ansprüche 1 bis 6, dadurch gekennzeichnet, daß das Erreichen des Sollwertes des den Schaltabstand beeinflussenden Wertes des einstellbaren Bauteils (4) dadurch erkannt wird, daß der Näherungsschalter einen signifikanten Schaltungszustand eingenommen hat.

8. Induktiver Näherungsschalter nach einem der Ansprüche 1 bis 7, dadurch gekennzeichnet, daß ein µController (7) vorgesehen ist.

9. Induktver Näherungsschalter nach Anspruch 8, dadurch gekennzeichnet, daß mit Hilfe des µControllers (7) die Aktivierung des Schalters (5, 6) regelmäßig überprüft wird.

10. Induktiver Näherungsschalter nach Anspruch 8, dadurch gekennzeichnet, daß die Aktivierung des Schalters (5, 6) einen "Interrupt" hervorruft und der "Interrupt" den µController (7) in den "Parameterprogrammiermodus" aktiviert.

11. Induktiver Näherungsschalter nach Anspruch 10, dadurch gekennzeichnet, daß ein Display, z. B. ein LCD, vorgesehen ist und die Programmierung im "Konversationsmodus" erfolgt.

## Claims

1. An inductive proximity switch with at least one component (4), e.g. a resistor, which is adjustable as regards its value which influences the switching distance, wherein the adjustable component (4) comprises at least one adjusting element, characterised in that a non-volatile memory (3) is provided as the adjusting element, the value of the adjustable component (4) which influences the switching distance can be adjusted as a digital word in the memory (3), the memory (3) automatically "runs up" or "runs down" on an actuation serving for the adjustment of the value of the adjustable component (4) which influences the switching distance, and the "run-up" or "run-down" of the memory (3) automatically ends when the value of the adjustable component (4) which influences the switching distance has reached a set value.

2. An inductive proximity switch according to claim 1, characterised in that the adjustment of the value of the adjustable component (4) which influences the switching distance, and therefore of the digital word, is effected by the actuation of at least one - preferably contactless - switch (5, 6).

3. An inductive proximity switch according to claim 2, characterised in that the switch (5, 6) operates inductively, capacitively, opto-electronically, or by making use of the Hall effect.

4. An inductive proximity switch according to any one of claims 1 to 3, characterised in that the "run-up" or "run-down" of the memory (3) occurs at different running speeds, and therefore "slow run-up" and "fast run-up" or "slow run-down" and "fast run-down" of the memory (3) are possible.

5. An inductive proximity switch according to claim 4, characterised in that different running speeds of the memory (3) can be obtained by a different length of actuation.

6. An inductive proximity switch according to any one of claims 3 to 5, characterised in that the "run-up" or "run-down" of the memory (3) is started by a first actuation and ended after a second actuation.

7. An inductive proximity switch according to any one of claims 1 to 6, characterised in that the attainmment of the set value of the value of the adjustable component (4) which influences the switching distance is recognised in that the proximity switch has adopted a significant switching state.

8. An inductive proximity switch according to any one of claims 1 to 7, characterised in that a microcontroller (7) is provided.

9. An inductive proximity switch according to claim 8, characterised in that the activation of the switch (5, 6) is regularly checked with the aid of the microcontroller (7).

10. An inductive proximity switch according to claim 8, characterised in that the activation of the switch (5, 6) causes an "interrupt" and the "interrupt" activates the microcontroller (7) into "parameter programming mode".

11. An inductive proximity switch according to claim 10, characterised in that a display, e.g. an LCD, is provided, and programming is effected in "conversation mode".

## Revendications

1. Commutateur de proximité inductif comportant au moins un composant (4) dont la valeur influençant la distance de commutation est réglable, par exemple une résistance, ledit composant réglable (4) présentant au moins un élément de réglage, caractérisé en ce qu'il est prévu comme élément de réglage une mémoire non volatile (3) dans laquelle la valeur du composant réglable (4) influençant la distance de commutation (4) peut être réglée sous la forme d'un mot numérique, en ce que la mémoire (3), lors d'une commande servant au réglage de la valeur du composant réglable (4) influençant la distance de commutation est "incrémentée" ou "décrémentée" automatiquement et l"'incrémentation" ou la "décrémentation" de la mémoire (3) se termine automatiquement lorsque la valeur du composant réglable (4) influençant la distance de commutation a atteint une valeur théorique.

2. Commutateur de proximité inductif selon la revendication 1, caractérisé en ce que le réglage de la valeur du composant réglable (4) influençant la distance de commutation, donc du mot numérique, est effectué par commande d'au moins un commutateur (5, 6), de préférence sans contacts.

3. Commutateur de proximité inductif selon la revendication 2, caractérisé en ce que le commutateur (5, 6) agit par voie inductive, capacitive ou électro-optique ou encore en tirant profit de l'effet Hall.

4. Commutateur de proximité inductif selon l'une quelconque des revendications 1 à 3, caractérisé en ce que l'"incrémentation" ou la "décrémentation" de la mémoire (3) se fait à différentes vitesses de fonctionnement, et il est donc possible d'introduire une "incrémentation lente" et une "incrémentation rapide" ou bien une "décrémentation lente" et une "décrémentation rapide".

5. Commutateur de proximité inductif selon la revendication 4, caractérisé en ce que l'on peut effectuer une commande de longueur différente de vitesses de fonctionnement différentes de la mémoire (3).

6. Commutateur de proximité inductif selon l'une quelconque des revendications 3 à 5, caractérisé en ce que l'"incrémentation" ou la "décrémentation" de la mémoire (3) commence par une première commande et se termine après une deuxième commande.

7. Commutateur de proximité inductif selon l'une quelconque des revendications 1 à 6, caractérisé en ce qu'on reconnaît qu'on a atteint la valeur théorique de la valeur du composant réglable (4) influençant la distance de commutation lorsque le commutateur de proximité a adopté un état de commutation significatif.

8. Commutateur de proximité inductif selon l'une quelconque des revendications 1 à 7, caractérisé en ce qu'il est prévu un microcontrôleur (7).

9. Commutateur de proximité inductif selon la revendication 8, caractérisé en ce que l'activation du commutateur (5, 6) est contrôlée régulièrement à l'aide du microcontrôleur (7).

10. Commutateur de proximité inductif selon la revendication 8, caractérisé en ce que l'activation du commutateur (5, 6) provoque une "interruption" et l'"interruption" active le microcontrôleur (7) en "mode de programmation paramétrique".

11. Commutateur de proximité inductif selon la revendication 10, caractérisé en ce qu'il est prévu un affichage, par exemple un LCD, et la programmation se fait en "mode de dialogue".
